# EUROPEAN PATENT APPLICATION

(11) **EP 4 636 478 A1**
(43) Date of publication of application: **22.10.2025**
(21) Application number: 24861349.9
(22) Date of filing: 29.02.2024
(51) Int. Cl.: G03F 1/62, G03F 7/20

(54) **EUV-TRANSMISSIVE FILM, PELLICLE, AND EXPOSURE METHOD**

(71) Applicant: NGK INSULATORS, LTD., Nagoya-shi, Aichi 4678530 (JP)
(72) Inventor: KASHIWAYA, Toshikatsu, Nagoya-shi, Aichi 4678530 (JP)
(74) Representative: Müller-Boré & Partner Patentanwälte PartG mbB
(86) International application number: PCT/JP2024/007655
(87) International publication number: WO 2025/182055

(57) **Abstract**

Provided is an EUV transmissive membrane that exhibits high EUV transmittance. The EUV transmissive membrane (10) has a three-layer configuration composed of a metallic beryllium layer (12) having a first side and a second side, a first nitride layer (14a) that covers the first side (12a) of the beryllium layer (12), wherein the first nitride layer includes at least one selected from the group consisting of silicon nitride, beryllium nitride, boron nitride, and zirconium nitride, and a second nitride layer (14b) that covers the second side (12b) of the beryllium layer (12), wherein the second nitride layer includes at least one selected from the group consisting of silicon nitride, beryllium nitride, boron nitride, and zirconium nitride. The EUV transmissive membrane (10) has an EUV transmittance of 88% or more at a wavelength of 13.5 nm.

## Description

### TECHNICAL FIELD

The present disclosure relates to an EUV transmissive membrane, pellicle, and exposure method.

### BACKGROUND ART

With miniaturization in semiconductor manufacturing process advancing year by year, various improvements have been made in each step. Particularly, in a photolithography step, extreme ultraviolet (EUV) light having a wavelength of 13.5 nm has begun to be used in place of conventional ArF exposure having a wavelength of 193 nm. As a result, the wavelength was reduced to 1/10 or less at once, and optical properties thereof were completely different. Since there is no material having a high transmittance to EUV light, however, there is still no practical pellicle, which serves as a particle adhesion-preventing membrane of, for example, a photomask (reticle). For this reason, device manufacturers currently cannot use pellicles when manufacturing semiconductor devices.

Therefore, a pellicle membrane has been developed. It is desirable to use Si, Be, Y, Zr, or the like having a high EUV transmittance as a core material of the pellicle membrane. Patent Literature 1 (JP6858817B) discloses a pellicle membrane including a core layer that contains a material substantially transparent for EUV radiation such as (poly-)Si and a cap layer that contains a material absorbing IR radiation.

In addition, Patent Literature 2 (JP2020-98227A) discloses a pellicle membrane stretched on one end face of a pellicle frame, the pellicle membrane having a main layer of single-crystal Si, and graphene on one side or both sides of the main layer. It has been proposed that when the main layer has graphene, the pellicle membrane is not damaged during pellicle fabrication and can exhibit sufficient mechanical strength.

### CITATION LIST

### PATENT LITERATURE

Patent Literature 1: JP6858817B
Patent Literature 2: JP2020-98227A

### SUMMARY OF INVENTION

The core material having high EUV transmittance used for the pellicle membrane as described above forms a natural oxide membrane of several nm on the surface thereof in air, and the oxide membrane absorbs EUV, resulting in a decrease in EUV transmittance of the pellicle membrane. In particular, Be is a material having high EUV transmittance, but a natural oxide membrane of 2 to 3 nm is considered to be formed on the surface thereof. The transmittance loss due to the oxide membrane is as large as 6 to 9%. In addition, the process of fabricating a pellicle membrane sometimes involves treatment using a gas other than air, such as fluorine or chlorine, an acid, or an alkali solution, which may generate a side reaction membrane on the surface of the core material, thereby decreasing the EUV transmittance. Therefore, it is desirable to form a protective layer on the surface of the core material to suppress the formation of these membranes.

However, while applying a reaction-inhibiting protective layer on the surface of a core material such as Si and Be can prevent a significant decrease in EUV transmittance of the pellicle membrane, such a protective layer also has lower EUV transmittance than the pure core material, leading to a decrease in the EUV transmittance of the pellicle membrane as a whole. For example, Ru may be used as a protection layer for a Be core material. In the case of a pellicle membrane with a three-layer structure (Ru/Be/Ru) in which 1 to 2 nm of Ru is provided on the front and back surfaces of the Be core material, the Ru protective layer causes an EUV transmission loss of about 3 to 6%, which significantly degrades the performance of the pellicle membrane.

The inventors have recently found that by adopting a three-layer configuration of nitride layer/metallic beryllium layer/nitride layer, it is possible to provide an EUV transmissive membrane that exhibits high EUV transmittance.

Accordingly, an object of the present invention is to provide an EUV transmissive membrane or pellicle that exhibits high EUV transmittance. Another object of the present invention is to provide an exposure method using an EUV transmissive membrane.

The present disclosure provides the following aspects.

### [Aspect 1]

An EUV transmissive membrane with a three-layer configuration consisting of:
a metallic beryllium layer having a first side and a second side,
a first nitride layer that covers the first side of the beryllium layer, wherein the first nitride layer comprises at least one selected from the group consisting of silicon nitride, beryllium nitride, boron nitride, and zirconium nitride, and
a second nitride layer that covers the second side of the beryllium layer, wherein the second nitride layer comprises at least one selected from the group consisting of silicon nitride, beryllium nitride, boron nitride, and zirconium nitride,
wherein the EUV transmissive membrane has an EUV transmittance of 88% or more at a wavelength of 13.5 nm.

### [Aspect 2]

The EUV transmissive membrane according to aspect 1, wherein the EUV transmissive membrane has a thickness of 7 to 30 nm.

### [Aspect 3]

The EUV transmissive membrane according to aspect 1 or 2, wherein the beryllium layer has a thickness of 5 to 25 nm.

### [Aspect 4]

The EUV transmissive membrane according to any one of aspects 1 to 3, wherein the first nitride layer and the second nitride layer each have a thickness of 1 to 5 nm.

### [Aspect 5]

A pellicle comprising:
a substrate having a first side and a second side, and a cavity at a center of the substrate,
an amorphous carbon layer that covers the first side of the substrate, and
the EUV transmissive membrane according to any one of aspects 1 to 4, which covers a surface of the amorphous carbon layer opposite to the substrate, wherein the EUV transmissive membrane is exposed as a free-standing membrane constituting a bottom surface of the cavity at a same level as a surface of the amorphous carbon layer.

### [Aspect 6]

The pellicle according to aspect 5, wherein the amorphous carbon layer has a thickness of 1 to 15 nm.

### [Aspect 7]

The pellicle according to aspect 5 or 6, wherein the substrate is a Si substrate.

### [Aspect 8]

The pellicle according to any one of aspects 5 to 7, further comprising a mask layer that covers the second side of the substrate.

### [Aspect 9]

The pellicle according to aspect 8, wherein the mask layer is a SiO₂ layer.

### [Aspect 10]

An exposure method, comprising the steps of:
providing a composite membrane with a five-layer configuration, wherein the composite membrane comprises a protective layer containing amorphous carbon on both sides of the EUV transmissive membrane according to any one of aspects 1 to 4;
installing the composite membrane with a five-layer configuration into an apparatus in which hydrogen plasma and/or hydrogen radicals or oxygen plasma and/or oxygen radicals are generated;
bringing hydrogen plasma and/or hydrogen radicals or oxygen plasma and/or oxygen radicals into contact with the composite membrane with a five-layer configuration to remove the protective layer; and
installing the EUV transmissive membrane with a three-layer configuration, from which the protective layer has been removed, into an EUV exposure apparatus, then transmitting EUV through the EUV transmissive membrane to perform pattern exposure on a photosensitive substrate plate in the EUV exposure apparatus.

### BRIEF DESCRIPTION OF DRAWINGS

Figure 1 is a schematic cross-sectional view illustrating an embodiment of an EUV transmissive membrane according to the present invention.
Figure 2A is a process flow diagram illustrating the first half of a manufacturing procedure for an EUV transmissive membrane.
Figure 2B is a process flow diagram illustrating the second half of a manufacturing procedure for an EUV transmissive membrane.

### DESCRIPTION OF EMBODIMENTS

### EUV Transmissive Membrane

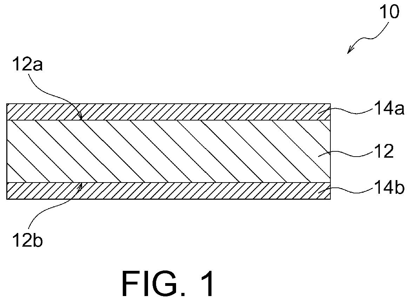

Figure 1 illustrates a schematic cross-sectional view of an EUV transmissive membrane 10 according to an embodiment of the present invention. The EUV transmissive membrane 10 is a membrane with a three-layer configuration consisting of a metallic beryllium layer 12, a first nitride layer 14a, and a second nitride layer 14b. The metallic beryllium layer 12 has a first side 12a and a second side 12b. The first nitride layer 14a is a layer that covers the first side 12a of the metallic beryllium layer 12 and contains at least one selected from the group consisting of silicon nitride, beryllium nitride, boron nitride, and zirconium nitride. The second nitride layer 14b is a layer that covers the second side 12b of the metallic beryllium layer 12 and contains at least one selected from the group consisting of silicon nitride, beryllium nitride, boron nitride, and zirconium nitride. The EUV transmissive membrane 10 has an EUV transmittance of 88% or more at a wavelength of 13.5 nm. Thus, by adopting a three-layer configuration of first nitride layer 14a/metallic beryllium layer 12/second nitride layer 14b, it is possible to provide the EUV transmissive membrane 10 that exhibits high EUV transmittance.

As mentioned above, a core material having high EUV transmittance may form a natural oxide membrane of several nm on the surface thereof in air. In addition, the process of fabricating a pellicle membrane sometimes involves treatment using a gas other than air, such as fluorine or chlorine, an acid, or an alkali solution, which may generate a side reaction membrane on the surface of the core material. The formation of such a membrane decreases the EUV transmittance of the pellicle membrane. Therefore, it is desirable to form a protective layer on the surface of the core material to suppress the formation of these membranes. However, applying a reaction-inhibiting protective layer to the surface of the core material leads to a decrease in the EUV transmittance of the pellicle membrane as a whole. A possible approach to address this problem is to provide an amorphous carbon layer as a protective membrane that can be removed by bringing hydrogen plasma and/or hydrogen radicals or oxygen plasma and/or oxygen radicals into contact with both sides of the EUV transmissive membrane. The above-described natural oxide membrane or side reaction membrane is formed before the pellicle membrane is fabricated, mounted on the EUV exposure apparatus, and subjected to the exposure process. However, the formation of the above-described membrane can be prevented by providing the amorphous carbon layer as a protective layer on both sides of the EUV transmissive membrane 10. In particular, the amorphous carbon layer is effective in protecting the EUV transmissive membrane 10 from various agents (e.g., fluorine-based etching agent with strong reactivity) used in a pellicle membrane fabricating process (e.g., free-standing membrane forming step). When the amorphous carbon layer is provided directly on the metallic beryllium layer 12, the amorphous carbon and metallic beryllium may react to form beryllium carbide. However, the EUV transmissive membrane 10 is composed of three layers of first nitride layer 14a/metallic beryllium layer 12/second nitride layer 14b and provided with the amorphous carbon layer on the nitride layers 14a and 14b. Thus, an undesirable reaction between amorphous carbon and metallic beryllium can be prevented. On the other hand, after serving as a protective layer in the pellicle membrane fabricating process (e.g., free-standing membrane forming step), the amorphous carbon layer becomes an unnecessary membrane in terms of reducing the EUV transmittance. For this reason, it is possible to attempt to improve the EUV transmittance by bringing the amorphous carbon layer into contact with hydrogen plasma and/or hydrogen radicals or oxygen plasma and/or oxygen radicals for removal. The EUV transmissive membrane 10 thus obtained has a three-layer configuration consisting of the metallic beryllium layer 12, the first nitride layer 14a, and the second nitride layer 14b, and no longer has a protective layer (amorphous carbon layer), so that a decrease in EUV transmittance due to the protective layer can be avoided. As a result, the EUV transmissive membrane 10 can maximize the high transmittance intrinsic to the three-layer configuration consisting of the metallic beryllium layer 12, the first nitride layer 14a, and the second nitride layer 14b, that is, can exhibit high EUV transmittance during exposure.

As described above, the EUV transmissive membrane 10 has high EUV transmittance. The EUV transmissive membrane 10 has an EUV transmittance of 88% or more, preferably 92% or more, more preferably 93% or more, even more preferably 94% or more, particularly preferably 95% or more, and most preferably 96% or more at a wavelength of 13.5 nm. A higher EUV transmittance of the EUV transmissive membrane 10 is desirable, and the upper limit thereof is not particularly limited. Although ideally 100%, the EUV transmissive membrane 10 typically has a EUV transmittance of 99% or less, and more typically 98% or less.

The metallic beryllium layer 12 is a layer containing metallic beryllium as a main component. Here, the "main component" in the metallic beryllium layer 12 means a component that accounts for 50 mol% or more, preferably 70 mol% or more, more preferably 80 mol% or more, and even more preferably 90 mol% or more of the metallic beryllium layer 12. The metallic beryllium layer 12 may also contain impurities in addition to metal beryllium as a main component. Accordingly, the metallic beryllium layer 12 may be composed of metallic beryllium and inevitable impurities. The thickness of the metallic beryllium layer 12 is preferably 5 to 25 nm, more preferably 7 to 20 nm, and even more preferably 9 to 15 nm.

The first nitride layer 14a and the second nitride layer 14b each contain at least one nitride selected from the group consisting of silicon nitride, beryllium nitride, boron nitride, and zirconium nitride. A particularly preferred nitride is silicon nitride. The advantages of providing the first nitride layer 14a and the second nitride layer 14b on both sides of the metallic beryllium layer 12 are as described above. The terms "silicon nitride", "beryllium nitride", "boron nitride", and "zirconium nitride" as used herein each mean a comprehensive composition that allows not only a stoichiometric composition such as Si₃N₄, Be₃N₂, BN, and ZrN, but also a non-stoichiometric composition such as Si₃N₄₋ₓ, wherein 0 < x < 4, Be₃N₂₋ₓ, wherein 0 < x < 2, BNₓ, wherein 0 < x < 1, and ZrNₓ, wherein 0 < x < 1. The first nitride layer 14a and the second nitride layer 14b each preferably have a thickness of 1 to 5 nm, and more preferably 1 to 3 nm.

The first nitride layer 14a, the metallic beryllium layer 12, and the second nitride layer 14b constitute, by only these layers, the EUV transmissive membrane 10. The these layers contribute to the realization of high EUV transmittance while ensuring basic functions as a pellicle membrane (such as a particle adhesion preventing function). The thickness of the EUV transmissive membrane 10 is preferably 7 to 30 nm, more preferably 9 to 26 nm, and even more preferably 11 to 21 nm.

When the first nitride layer 14a and/or the second nitride layer 14b each contain beryllium nitride, the EUV transmissive membrane 10 preferably has a nitrogen concentration gradient region where nitrogen concentration decreases as closer to the metallic beryllium layer 12. In other words, when the composition of beryllium nitride may include from the stoichiometric composition such as Be₃N₂ to the non-stoichiometric composition such as Be₃N₂₋ₓ, wherein 0 < x <2, as described above, the beryllium nitride constituting the beryllium nitride layer preferably has a gradient composition that is richer in beryllium as closer to the metallic beryllium layer 12. As a result, it is possible to improve the adhesion between the nitride layers 14a and 14b (i.e., beryllium nitride layer) constituting the EUV transmissive membrane 10 and the metallic beryllium layer 12 and relieve the generation of stress caused by the difference in thermal expansion between these layers. That is, it is possible to improve the adhesion between these layers to suppress delamination, and to make delamination difficult as a thermal expansion relaxation layer between these layers in the case of absorbing EUV light and becoming a high temperature. The thickness of the nitrogen concentration gradient region is preferably smaller than that of each of the nitride layers 14a and 14b. In other words, the entire thickness of each of the nitride layers 14a and 14b does not need to be in the nitrogen concentration gradient region. For example, it is preferable that only a part of the thickness of each of the nitride layers 14a and 14b, for example, a region of preferably 10 to 70% and more preferably 15 to 50% of the thickness of each of the nitride layers 14a and 14b is the nitrogen concentration gradient region.

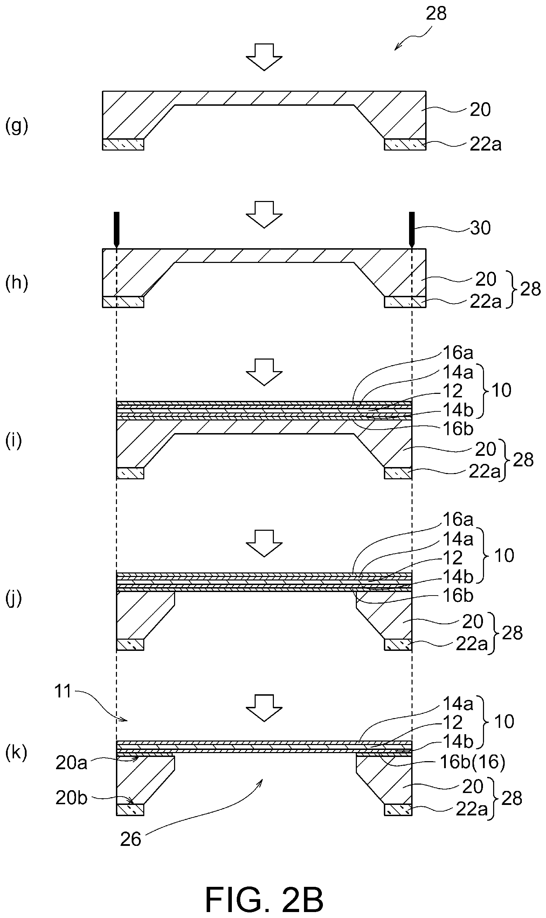

In the EUV transmissive membrane 10, the main region for transmitting EUV is preferably in a form of the free-standing membrane. In other words, it is preferable that the substrate 20 or the like (e.g., Si substrate) used at the time of deposition remains as a border only at the outer edge of the EUV transmissive membrane 10 as a pellicle 11 illustrated in Figure 2B(k) described later, that is, no substrate or the like (e.g., Si substrate) remains in the main region other than the outer edge. In short, the main region preferably consists only of three layers of the first nitride layer 14a, the metallic beryllium layer 12, and the second nitride layer 14b.

### Manufacturing Method

After a composite membrane with a five-layer configuration including a protective layer that contains amorphous carbon on both sides of an EUV transmissive membrane is formed on a Si substrate, the EUV transmissive membrane or pellicle according to the present invention can be fabricated by removing an unnecessary portion of the Si substrate and the protective layer through etching to form a free-standing membrane. Accordingly, the main portion of the EUV transmissive membrane is in the form of the free-standing membrane in which no Si substrate remains as described above.

### (1) Preparation of Si Substrate

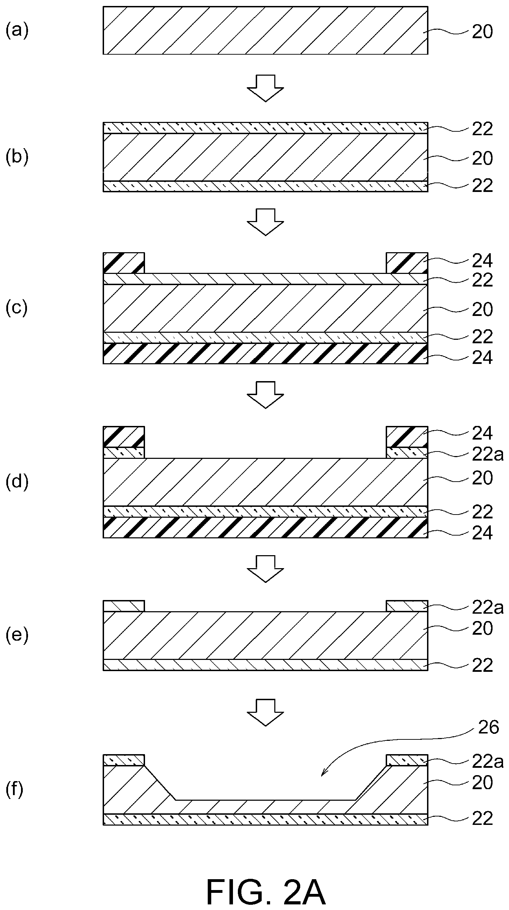

First, as illustrated in Figure 2B, a Si substrate 28 for forming a composite membrane thereon is prepared. After the composite membrane composed of the second protective layer 16b, the second nitride layer 14b, the metallic beryllium layer 12, the first nitride layer 14a, and the first protective layer 16a is formed on the Si substrate 28, the main region (i.e., a region to be a free-standing membrane) other than the outer edge of the Si substrate is removed by etching. Accordingly, it is desirable to reduce the thickness of the Si substrate in the region to be formed into the free-standing membrane in advance in order to perform the etching efficiently in a short time. Therefore, it is desirable that a mask corresponding to the EUV transmission shape is formed on the Si substrate by employing a normal semiconductor process, and the Si substrate is etched by wet etching to reduce the thickness of the main region of the Si substrate to a predetermined thickness. The wet-etched Si substrate is cleaned and dried to prepare a Si substrate having a cavity formed by wet etching. The wet etching mask may be made of any material that is corrosion resistance to Si wet etchant, for example, SiO₂ is suitable for use. In addition, the wet etchant is not particularly limited as long as it is capable of etching Si. For example, TMAH (tetramethylammonium hydroxide) is preferred because it can be used under appropriate conditions, and very good anisotropic etching can be performed on Si.

### (2) Formation of Composite Membrane

The composite membrane composed of the second protective layer 16b, the second nitride layer 14b, the metallic beryllium layer 12, the first nitride layer 14a, and the first protective layer 16a is formed in order on the Si substrate. The composite membrane may be formed by any deposition method. An example of the preferred deposition method is the sputtering method. It is preferable that the metallic beryllium layer 12 is fabricated by sputtering using a pure Be target.

The first nitride layer 14a and the second nitride layer 14b are also preferably fabricated by sputtering. For example, the nitride layers 14a and 14b may be formed by (i) forming a Si, Be, B or Zr membrane by sputtering using a Si, Be, B, or Zr target and then irradiating the membrane with nitrogen plasma to cause a nitriding reaction of Si, Be, B, or Zr. The first nitride layer 14a and the second nitride layer 14b may also be fabricated by (ii) reactive sputtering. The reactive sputtering can be performed, for example, by adding nitrogen gas to the chamber during sputtering using a Si, Be, B, or Zr target, whereby Si, Be, B, or Zr and nitrogen react to each other to generate silicon nitride, beryllium nitride, boron nitride, or zirconium nitride. Alternatively, the nitride layers 14a and 14b may be directly formed by (iii) sputtering using a Si₃N₄, Be₃N₂, BN, or ZrN target. Nitrogen gas may be added to the chamber during the sputtering, whereby Si, Be, B, or Zr and nitrogen react to each other as in the case of the reactive sputtering (ii) above to promote the generation of silicon nitride, beryllium nitride, boron nitride, or zirconium nitride.

Each of the first protective layer 16a and the second protective layer 16b is a layer containing amorphous carbon. The layer containing amorphous carbon is advantageous in that, in addition to exhibiting high protection performance against various agents (e.g., fluorine-based etching agent with strong reactivity) used in a pellicle membrane fabricating process (e.g., free-standing membrane forming step), the layer reduces the impact of the residue on the EUV transmissive membrane 10 when the protective layers 16a and 16b are removed, and that the protective layers 16a and 16b are easily removed. The first protective layer 16a and the second protective layer 16b preferably contains amorphous carbon as a main component, and more preferably is composed of amorphous carbon. In general, amorphous carbon does not have a completely disordered atomic arrangement but microscopically has a crystal structure (i.e., it has crystallites). Such crystallites are often arranged in a disordered manner, making them amorphous as a whole. In particular, diamond-like carbon (DLC) refers to a material containing many crystallites with a cubic four-coordinated structure, such as diamond, while graphite-like carbon (GLC) refers to a material containing many crystallites with a planar three-coordinated structure, such as graphite. The first protective layer 16a and the second protective layer 16b may be carbon with a completely disordered atomic arrangement, carbon having crystallites in a disordered manner, or even amorphous carbon that is not completely dense but rather contains fine pores. Here, the "main component" in the first protective layer 16a and the second protective layer 16b means a component that accounts for 50% by weight or more, preferably 60% by weight or more, more preferably 70% by weight or more, and even more preferably 80% by weight or more of the total weight of the first protective layer 16a or the second protective layer 16b. Meanwhile, the first protective layer 16a and the second protective layer 16b may be composed only of amorphous carbon. The first protective layer 16a and the second protective layer 16b each preferably have a thickness of 1 to 15 nm, more preferably 2 to 12 nm, and even more preferably 3 to 10 nm. It is preferable that the formation of the amorphous carbon layer as the first protective layer 16a and the second protective layer 16b is performed by sputtering using a graphite target.

The method of forming the metallic beryllium layer 12, the nitride layers 14a and 14b, and the protective layers 16a and 16b is not limited thereto. The metallic beryllium layer 12, the nitride layers 14a and 14b, and the protective layers 16a and 16b may be formed in a one-chamber sputtering apparatus as in Examples described later, or a multi-chamber sputtering apparatus may be used to form the metallic beryllium layer 12, the nitride layers 14a and 14b, and the protective layers 16a and 16b in separate chambers.

In the case where the first nitride layer 14a and the second nitride layer 14b are beryllium nitride layers including a nitrogen concentration gradient region, that is, in the case of forming a nitrogen concentration gradient region in the EUV transmissive membrane 10 with a three-layer structure of beryllium nitride/beryllium/beryllium nitride, when depositing the beryllium nitride membrane and metallic beryllium, the introduction of nitrogen gas may be stopped and switched to metallic beryllium deposition while continuing sputtering using a pure Be target with nitrogen gas in the chamber. In this way, a region is formed in which the nitrogen concentration in the film-deposited membrane decreases in the thickness direction as the concentration of nitrogen gas in the chamber decreases. On the other hand, in the case of switching the metallic beryllium to the beryllium nitride, the nitrogen concentration gradient region can be formed by starting the introduction of nitrogen gas in the middle of the process while sputtering is performed, contrary to the above. The thickness of the nitrogen concentration gradient region can be controlled by adjusting the time for which the nitrogen gas concentration is changed.

### (3) Free-standing Membrane Formation

An unnecessary portion of the Si substrate other than the outer edge of the Si substrate 28 where the composite membrane is formed, which is left as a border, is removed by etching to make the composite membrane free-standing. Etching of Si may be performed by any method, but etching with XeF₂ is preferred. Subsequently, the exposed portions of the first protective layer 16a and the second protective layer 16b are removed to obtain the EUV transmissive membrane 10 with a three-layer configuration consisting of the metallic beryllium layer 12, the first nitride layer 14a, and the second nitride layer 14b in the form of the pellicle 11. Particularly, after the free-standing membrane forming step using a fluorine-based etching agent such as XeF₂ described above, the first protective layer 16a and the second protective layer 16b become an unnecessary membrane in terms of reducing the EUV transmittance because the strong protective function against the fluorine-based etching agent is no longer required. Therefore, after the composite membrane is made into a free-standing membrane, the EUV transmittance can be further enhanced by removing the protective layers 16a and 16b. The processing for removing the amorphous carbon layer, which serves as the first protective layer 16a and the second protective layer 16b, is preferably performed by installing a composite membrane including the EUV transmissive membrane 10 into an apparatus in which hydrogen plasma and/or hydrogen radicals or oxygen plasma and/or oxygen radicals are generated, then bringing hydrogen plasma and/or hydrogen radicals or oxygen plasma and/or oxygen radicals into contact with the composite membrane. The amorphous carbon layer, which serves as the first protective layer 16a and the second protective layer 16b, is exposed to a hydrogen plasma and/or hydrogen radical atmosphere or an oxygen plasma and/or oxygen radical atmosphere, whereby C on the surface of the amorphous carbon layer reacts with H to remove the amorphous carbon layer. As a result, the entire first protective layer 16a and the exposed portion of the second protective layer 16b can be eliminated. On the other hand, the second protective layer 16b interposed between the Si substrate 28 and the second nitride layer 14b is left intact to constitute the amorphous carbon layer 16 of the pellicle 11.

### Pellicle

Accordingly, as illustrated in Figure 2B(k), the EUV transmissive membrane 10 is preferably provided in the form of the pellicle 11. The pellicle 11 includes the substrate 20, the amorphous carbon layer 16, and the EUV transmissive membrane 10. The substrate 20 has a first side 20a, a second side 20b, and a cavity 26 at the center thereof. The substrate 20 is preferably a Si substrate or a border made of Si. The first side 20a of the substrate 20 is covered with the amorphous carbon layer 16. The EUV transmissive membrane 10 covers a surface of the amorphous carbon layer 16 opposite to the substrate 20, and the EUV transmissive membrane 10 is exposed as a free-standing membrane constituting a bottom surface of the cavity 26 at the same level as the surface of the amorphous carbon layer 16.

The amorphous carbon layer 16 is a layer containing amorphous carbon. The amorphous carbon layer 16 located directly below the second nitride layer 14b (i.e., second protective layer 16b) contributes to the improvement of the strength of the second nitride layer 14b. In other words, the amorphous carbon layer 16 contributes to the improvement of crystallinity of the second nitride layer 14b deposited thereon, and as a result, the density and strength of the second nitride layer 14b can be enhanced. That is, when the second nitride layer 14b is directly deposited on the substrate 20 in the absence of the amorphous carbon layer 16, the crystallinity of the nitride at the initial stage of deposition deteriorates, which leads to a decrease in the density and strength of the nitride. In this regard, when layer-deposited on the substrate 20 via the amorphous carbon layer 16, a membrane with high nitride crystallinity is obtained as the second nitride layer 14b. Since the amorphous carbon layer 16 corresponds to the second protective layer 16b described above, the foregoing description of the second protective layer 16b is simply applied to the amorphous carbon layer 16. Accordingly, the thickness of the amorphous carbon layer 16 is preferably 1 to 15 nm, more preferably 2 to 12 nm, and even more preferably 3 to 10 nm.

The pellicle 11 may further include a mask layer 22a that covers a second side 20b of the substrate 20. The mask layer 22a is preferably a SiO₂ layer.

### Exposure Method

According to a preferred aspect of the present invention, the following exposure method using the EUV transmissive membrane 10 is provided. In this method, first, a composite membrane with a five-layer configuration including a first protective layer 16a and a second protective layer 16b that contain amorphous carbon on both sides of the EUV transmissive membrane 10 is prepared, as illustrated in Figure 2B(j). After the composite membrane with a five-layer configuration installed into an apparatus in which hydrogen plasma and/or hydrogen radicals or oxygen plasma and/or oxygen radicals are generated, hydrogen plasma and/or hydrogen radicals or oxygen plasma and/or oxygen radicals are brought into contact with the composite membrane with a five-layer configuration to remove exposed portions of the first protective layer 16a and the second protective layer 16b. At this time, as illustrated in Figure 2B(k), the second protective layer 16b interposed between the border 20 made of Si and the second nitride layer 14b is left intact to constitute the amorphous carbon layer 16 of the pellicle 11. The pellicle 11 including the EUV transmissive membrane 10 with a three-layer configuration, from which the first protective layer 16a and the second protective layer 16b have been removed in this way, is installed into an EUV exposure apparatus, and then EUV is transmitted through the EUV transmissive membrane 10 to perform pattern exposure on a photosensitive substrate plate in the EUV exposure apparatus.

### EXAMPLES

The present invention will be described in more detail with reference to the following examples. However, the present invention is not limited to the following examples.

### Example 1 (Reference)

According to the procedures illustrated in Figures 2A and 2B, a composite free-standing membrane (EUV transmissive membrane 10 with protective layers 16a and 16b provided on both sides thereof) with a five-layer configuration of amorphous carbon/silicon nitride/Be/silicon nitride/amorphous carbon was fabricated as follows.

### (1) Preparation of Si Substrate

A Si wafer 20 having a diameter of 8 inches (20.32 cm) was prepared (Figure 2A (a)). A SiO₂ membrane 22 having a thickness of 50 nm was formed on both sides of the Si wafer 20 by thermal oxidation (Figure 2A (b)). Resist was applied to both sides of the Si wafer 20, and a resist mask 24 for SiO₂ etching was formed by exposure and development so that a 110 mm × 145 mm resist hole was created on one side (Figure 2A(c)). An exposed portion of the SiO₂ membrane 22 was etched and removed by wet-etching one side of the substrate with hydrofluoric acid to fabricate a SiO₂ mask as the mask layer 22a (Figure 2A(d)). The resist mask 24 for SiO₂ etching was removed with an ashing apparatus (Figure 2A(e)). Si was then wet-etched with a TMAH solution. This etching was performed only for an etching time to obtain a target Si substrate having thickness of 50 µm with an etching rate measured in advance (Figure 2A(f)). Finally, the SiO₂ membrane 22 formed on the surface not subjected to Si etching was removed and cleaned with hydrofluoric acid to prepare a Si substrate 28 (Figure 2B(g)). The Si substrate outline may be diced with a laser 30, if necessary (Figure 2B (h)), to achieve the desired shape (Figure 2B (i)). In this way, a 110 mm × 145 mm cavity 26 was provided at the center of the 8-inch (20.32 cm) Si wafer 20 to prepare the Si substrate 28 having a Si thickness of 50 µm in the cavity 26 portion.

### (2) Formation of Composite Membrane

On the Si substrate 28 including the cavity 26 obtained in (1) above, a composite membrane with a five-layer structure of amorphous carbon/silicon nitride/Be/silicon nitride/amorphous carbon was formed as follows (Figure 2B(i)). First, the Si substrate plate 28 was set in a multi-target sputtering apparatus, and a graphite target, Si₃N₄ target and a pure Be target were attached thereto. A chamber was evacuated, the graphite target was used to carry out sputtering only with argon gas at an internal pressure of 0.3 Pa, and the sputtering was terminated at the time when 2 nm of diamond-like carbon (DLC) was layer-deposited as amorphous carbon. Subsequently, the chamber was evacuated again, the Si₃N₄ target was used to carry out sputtering only with argon gas at an internal pressure of 0.7 Pa, and the sputtering was terminated at the time when 2 nm of Si₃N₄ was layer-deposited. Furthermore, the chamber was evacuated again, the pure Be target was used to carry out sputtering only with argon gas at an internal pressure of 0.5 Pa, and the sputtering was terminated at the time when 20 nm of beryllium was layer-deposited. Subsequently, the chamber was evacuated again, the Si₃N₄ target was used to carry out sputtering only with argon gas at an internal pressure of 0.7 Pa, and the sputtering was terminated at the time when 2 nm of Si₃N₄₋ₓ was layer-deposited. Thereafter, sputtering was performed using the graphite target in the same manner as in the first step, and the sputtering was terminated at the time when 2 nm of amorphous carbon was layer-deposited. In this manner, a composite membrane with 2 nm of amorphous carbon (C)/2 nm of silicon nitride (Si₃N₄₋ₓ)/20 nm of beryllium (Be)/2 nm of silicon nitride (Si₃N₄₋ₓ)/2 nm of amorphous carbon (C) was formed. In other words, the composite membrane has a five-layer configuration consisting of the EUV transmissive membrane 10, which is composed of three layers of the first nitride layer 14a, the metallic beryllium layer 12, and the second nitride layer 14b, and the first protective layer 16a, and the second protective layer 16b, wherein the first protective layer 16a and the second protective layer 16b containing amorphous carbon as a main component are formed on both sides of the EUV transmissive membrane 10.

### (3) Free-standing Membrane Formation

The Si substrate 28 with the composite membrane prepared in (2) above was set in a chamber of an XeF₂ etcher capable of processing an 8-inch (20.32 cm) substrate. The chamber was sufficiently evacuated. At this time, if moisture remains in the chamber, the moisture reacts with the XeF₂ gas to generate hydrofluoric acid, and corrosion of the etcher or unexpected etching occurs. Therefore, the sufficient evacuation was performed. If necessary, vacuuming and nitrogen gas introduction were repeated in the chamber to reduce residual moisture in the chamber. When the sufficient evacuation was achieved, a valve between a XeF₂ material tank and a preliminary space was opened. As a result, XeF₂ was sublimated, and XeF₂ gas was also accumulated in the preliminary space. When the XeF₂ gas was sufficiently accumulated in the preliminary space, the valve between the preliminary space and the chamber was opened to introduce the XeF₂ gas into the chamber. The XeF₂ gas was decomposed into Xe and F, and F reacted with Si to generate SiF₄. Since the boiling point of SiF₄ was -95°C, SiF₄ generated was rapidly evaporated, causing a reaction of F with the newly exposed Si substrate. When the Si etching proceeded and F in the chamber decreased, the chamber was evacuated, and the XeF₂ gas was introduced into the chamber again to perform the etching. In this manner, the evacuation, the introduction of the XeF₂ gas, and the etching were repeated, and the etching was continued until the Si substrate 28 corresponding to the portion to be formed into the free-standing membrane disappeared. When the Si substrate of the unnecessary portion disappeared, the etching was terminated. In this way, a composite free-standing membrane with a five-layer configuration having a border 20 made of Si is obtained (Figure 2B(j)).

### Example 2 (Reference)

A composite free-standing membrane (EUV transmissive membrane 10 with protective layers 16a and 16b provided on both sides thereof) having a border 20 made of Si was fabricated in the same manner as in Example 1. Thereafter, amorphous carbon layers exposed on both sides of the composite free-standing membrane were etched with hydrogen plasma to reduce the thickness of each amorphous carbon layer to 1 nm. In this manner, a composite free-standing membrane with a five-layer configuration consisting of 1 nm of amorphous carbon (C)/2 nm of silicon nitride (Si₃N₄₋ₓ)/20 nm of beryllium (Be)/2 nm of silicon nitride (Si₃N₄₋ₓ)/1 nm of amorphous carbon (C), which had a border 20 made of Si, was obtained (Figure 2B(j)).

### Example 3

A composite free-standing membrane (EUV transmissive membrane 10 with protective layers 16a and 16b provided on both sides thereof) having a border 20 made of Si was fabricated in the same manner as in Example 1. Thereafter, amorphous carbon layers exposed on both sides of the EUV transmissive membrane 10 were etched with hydrogen plasma to remove each of the amorphous carbon layers other than the amorphous carbon layer 16 in a portion sandwiched between the EUV transmissive membrane 10 and the border 20 made of Si. In this manner, a composite free-standing membrane (i.e., EUV transmissive membrane 10) with a three-layer configuration consisting of 2 nm of silicon nitride (Si₃N₄₋ₓ)/20 nm of beryllium (Be)/2 nm of silicon nitride (Si₃N₄₋ₓ), which had the border 20 made of Si, was obtained in the form of the pellicle 11 (Figure 2B(k)).

### Example 4

A composite free-standing membrane (EUV transmissive membrane 10 with protective layers 16a and 16b provided on both sides thereof) having a border 20 made of Si was fabricated in the same manner as in Example 1, except that a composite membrane with 12 nm of amorphous carbon (C)/1 nm of silicon nitride (Si₃N₄₋ₓ)/20 nm of beryllium (Be)/1 nm of silicon nitride (Si₃N₄₋ₓ)/12 nm of amorphous carbon (C) was formed by changing each of the deposition time of amorphous carbon and silicon nitride in (2) above. Thereafter, amorphous carbon layers exposed on both sides of the EUV transmissive membrane 10 were etched with hydrogen plasma to remove each of the amorphous carbon layers other than the amorphous carbon layer 16 in a portion sandwiched between the EUV transmissive membrane 10 and the border 20 made of Si. In this manner, a composite free-standing membrane (i.e., EUV transmissive membrane 10) with a three-layer configuration consisting of 1 nm of silicon nitride (Si₃N₄₋ₓ)/20 nm of beryllium (Be)/1 nm of silicon nitride (Si₃N₄₋ₓ), which had the border 20 made of Si, was obtained in the form of the pellicle 11 (Figure 2B(k)).

### EUV Transmittance and In-plane Uniformity thereof

EUV light was irradiated onto a free-standing membrane as the EUV transmissive membrane fabricated in Examples 1 to 3 at a power of 600 W in a hydrogen atmosphere of 20 Pa for 15 minutes, and then the amount of transmitted EUV light was measured with a sensor. When the EUV transmittance was determined by comparing the obtained measurement value with a value obtained by directly measuring the amount of EUV light with a sensor without using the EUV transmissive membrane, the results shown in Table 1 were obtained. At this time, a spot of the EUV light used for measuring the transmittance had an elliptical shape of 0.5 mm × 0.2 mm, and the EUV transmittance was measured at a wavelength of 13.5 nm within the spot size. Therefore, in order to evaluate the in-plane uniformity of the EUV transmittance, the EUV transmittance at each place was determined by measuring the EUV transmittance while moving the spot of the EUV light, and the value of the in-plane variation was calculated from the data as a value three times the standard deviation. Accordingly, the smaller value of the in-plane variation refers to better in-plane uniformity of the EUV transmittance.

### [Table 1]

**TABLE 1**

| | Component and thickness (nm)of each layer | | | | | EUV properties | |
|---|---|---|---|---|---|---|---|
| | First protective layer | First nitride layer | Metallic beryllium layer | Second nitride layer | Second protective layer | EUV transmittance (%) | In-plane variation in EUV transmittance (%) |
| | C | Si₃N₄₋ₓ | Be | Si₃N₄₋ₓ | C | | |
| Example 1* | 2 | 2 | 20 | 2 | 2 | 91.1 | 0.2 |
| Example 2* | 1 | 2 | 20 | 2 | 1 | 92.6 | 0.3 |
| Example 3 | None | 2 | 20 | 2 | None | 93.8 | 0.5 |
| Example 4 | None | 1 | 20 | 1 | None | 94.7 | 0.4 |

| | | | | | | | |
|---|---|---|---|---|---|---|---|
| * represents a reference example. | | | | | | | |

As can be seen from the results, when the amorphous carbon layer is left as in Examples 1 and 2, the in-plane variation in the EUV transmittance is small. Thus, while the in-plane uniformity becomes excellent, the EUV transmittance becomes low. In contrast, the removal of the amorphous carbon layer by etching, as in Examples 3 and 4, can increase a transmittance while ensuring acceptable in-plane uniformity. Although a smaller in-plane variation in the EUV transmittance has the advantage of making the in-plane exposure amount more uniform and improving device homogeneity, a higher EUV transmittance results in shorter exposure time, that is, higher throughput is achieved. In other words, the present invention provides an EUV transmissive membrane that exhibits high EUV transmittance.

In addition, Example 4 is an aspect in which the thickness of the amorphous carbon layer as the first protective layer 16a and the second protective layer 16b is 12 µm, which is greater than the thickness (2 µm) of the amorphous carbon layer of Examples 1 to 3, whereby the protective function against a fluorine-based etching agent is enhanced. As shown in Table 1, it is possible to realize high EUV transmittance by finally removing the protective layers 16a and 16b in the present invention, so that the protective function described above can be enhanced by thickening the amorphous carbon layer as the protective layers 16a and 16b as in Example 4.

## Claims

1. An EUV transmissive membrane with a three-layer configuration consisting of:
a metallic beryllium layer having a first side and a second side,
a first nitride layer that covers the first side of the beryllium layer, wherein the first nitride layer comprises at least one selected from the group consisting of silicon nitride, beryllium nitride, boron nitride, and zirconium nitride, and
a second nitride layer that covers the second side of the beryllium layer, wherein the second nitride layer comprises at least one selected from the group consisting of silicon nitride, beryllium nitride, boron nitride, and zirconium nitride,
wherein the EUV transmissive membrane has an EUV transmittance of 88% or more at a wavelength of 13.5 nm.

2. The EUV transmissive membrane according to claim 1, wherein the EUV transmissive membrane has a thickness of 7 to 30 nm.

3. The EUV transmissive membrane according to claim 1 or 2, wherein the beryllium layer has a thickness of 5 to 25 nm.

4. The EUV transmissive membrane according to claim 1 or 2, wherein the first nitride layer and the second nitride layer each have a thickness of 1 to 5 nm.

5. A pellicle comprising:
a substrate having a first side and a second side, and a cavity at a center of the substrate,
an amorphous carbon layer that covers the first side of the substrate, and
the EUV transmissive membrane according to claim 1 or 2, which covers a surface of the amorphous carbon layer opposite to the substrate, wherein the EUV transmissive membrane is exposed as a free-standing membrane constituting a bottom surface of the cavity at a same level as a surface of the amorphous carbon layer.

6. The pellicle according to claim 5, wherein the amorphous carbon layer has a thickness of 1 to 15 nm.

7. The pellicle according to claim 5, wherein the substrate is a Si substrate.

8. The pellicle according to claim 5, further comprising a mask layer that covers the second side of the substrate.

9. The pellicle according to claim 8, wherein the mask layer is a SiO₂ layer.

10. An exposure method, comprising the steps of:
providing a composite membrane with a five-layer configuration, wherein the composite membrane comprises a protective layer containing amorphous carbon on both sides of the EUV transmissive membrane according to claim 1 or 2;
installing the composite membrane with a five-layer configuration into an apparatus in which hydrogen plasma and/or hydrogen radicals or oxygen plasma and/or oxygen radicals are generated;
bringing hydrogen plasma and/or hydrogen radicals or oxygen plasma and/or oxygen radicals into contact with the composite membrane with a five-layer configuration to remove the protective layer; and
installing the EUV transmissive membrane with a three-layer configuration, from which the protective layer has been removed, into an EUV exposure apparatus, then transmitting EUV through the EUV transmissive membrane to perform pattern exposure on a photosensitive substrate plate in the EUV exposure apparatus.
